# EUROPEAN PATENT APPLICATION

(11) **EP 2 518 449 A2**
(43) Date of publication of application: **31.10.2012**
(21) Application number: 12275054.0
(22) Date of filing: 27.04.2012
(51) Int. Cl.: G01D 4/00

(54) **Power monitoring apparatus of standby power saving type, electric load device, and power monitoring method**

(30) Priority: 29.04.2011 KR 20110041008
(71) Applicant: Samsung Electro-Mechanics Co., Ltd, Suwon, Gyunggi-Do (KR)
(72) Inventor: Moon, Ung Han, 442-700 Gyeonggi-do, (KR); Yun, Jong Chull, 445-730 Gyeonggi-do, (KR); Yang, Chang Soo, 462-709 Gyeonggi-do, (KR)
(74) Representative: Powell, Timothy John

(57) **Abstract**

Provided are a power monitoring apparatus of standby power saving type, an electric load device, and a power monitoring method. The power monitoring apparatus of standby power saving type includes: a power metering module measuring a power consumption situation of an electric load device, transmitting a measured result to a communication module, and switching off when a standby mode of the electric load device is held for more than a preset time or the electric load device is off; the communication module being supplied with power upon the switching-on, transmitting a power consumption value received from the power metering module to exterior, being supplied with standby power upon the switching-off to wait for receiving a call signal, and switching on a switch upon reception of the call signal; and a charging module starting charging upon the switching-on, and supplying standby power to the communication module upon the switching-off.

## Description

### CROSS-REFERENCE TO RELATED APPLICATIONS

This application claims the benefit of Korean Patent Application No. 10-2011-0041008 filed with the Korea Intellectual Property Office on April 29, 2011, the disclosure of which is incorporated herein by reference.

### BACKGROUND OF THE INVENTION

### 1. Field of the Invention

The present invention relates to a power monitoring apparatus of standby power saving type, an electric load device, and a power monitoring method. In particular, the present invention relates to a power monitoring apparatus of standby power saving type, an electric load device, and a power monitoring method, which are capable of shutting down or saving standby power separately consumed in the power monitoring apparatus when the electric load device is in a standby mode.

### 2. Description of the Related Art

Due to energy problems arising from high oil prices, a variety of technologies for saving energies of electric load devices have recently been developed. In particular, many smart grid technologies have been proposed to efficiently manage power consumed in homes and so on.

As such smart grid technologies, many intelligent power metering technologies have been proposed. Generally, an intelligent power metering reduces power consumption of an electric load device by monitoring power of the electric load device, in real time, using a power metering function and a communication function.

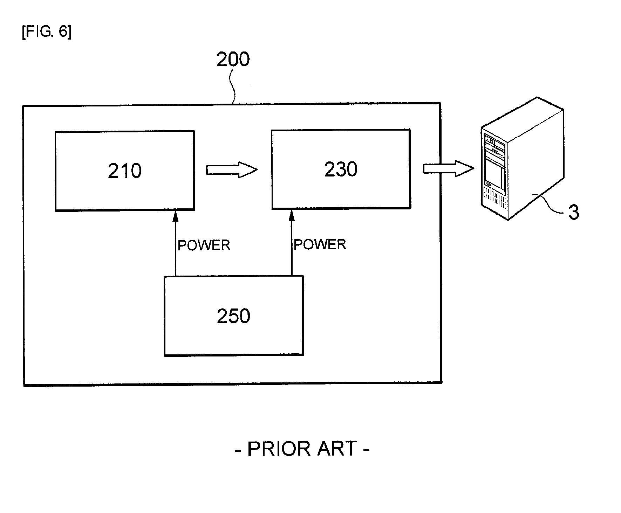

A power metering technology applied to a conventional smart grid is shown in FIG. 6. FIG. 6 schematically shows a conventional power monitoring apparatus of standby power saving type.

A conventional power monitoring apparatus 200 will be described below with reference to FIG. 6. The conventional power monitoring apparatus 200 includes a power metering module 210 configured to measure power consumption of a load device (not shown) in real time, a communication module 230 configured to transmit the power consumption measured by the power metering module 210 to the exterior, for example, an external server 3, through a communication network, and a power module 250 configured to supply power to the power metering module 210 and the communication module 230.

At this time, even in a standby mode that reduces power consumption in the electric load device, the power metering module 210 and the communication module 230 included in the power monitoring apparatus 200 of FIG. 6 continuously consume power. Generally, in the power monitoring apparatus 200 of FIG. 6, the power metering module 210 basically consumes power of about 1.5 W during the real-time power measurement, and the communication module 230 consumes more power during the real-time data transmission.

Currently, as smart grid technologies have advanced, standby power consumed in a general smart household appliance (load device) has been reduced to about 1 W to 2 W. However, products capable of saving power consumed in a power monitoring apparatus measuring the power consumption of the smart household appliance (load device) have not yet been developed.

Therefore, in the smart grid technology, there is a need for minimizing the power consumption of the electric load device and saving power consumed in the power monitoring apparatus measuring the power consumption of the load device.

### SUMMARY OF THE INVENTION

The present invention has been invented in order to overcome the above-described problems and it is, therefore, an object of the present invention to provide a power monitoring apparatus of standby power saving type, which is capable of shutting down or saving standby power separately consumed in the power monitoring apparatus when an electric load device is in a standby power mode, and to provide an electric load device including the power monitoring apparatus of the standby power saving type, and a power monitoring method of standby power saving type.

In accordance with one aspect of the present invention to achieve the object, there is provided a power monitoring apparatus of standby power saving type, including: a power metering module configured to operate when supplied with power upon the switching-on of a switch, measure a power consumption situation of an electric load device, transmit a measured result to a communication module, and switch off the switch when a standby mode of the electric load device according to the measured result is held for more than a preset time or when the electric load device is powered off; the communication module configured to be supplied with power upon the switching-on of the switch, transmit a power consumption value received from the power metering module to exterior, be supplied with standby power upon the switching-off of the switch to wait for receiving a call signal, and switch on the switch upon reception of the call signal; and a charging module configured to start charging upon the switching-on of the switch, and supply standby power to the communication module upon the switching-off.

The power monitoring apparatus may further include: a power module configured to be supplied with some of power being supplied to the electric load device or be supplied with power from the electric load device upon the switching-on, and supply the power to the power metering module, the communication module, and the charging module.

The power module may change from the switching-off state of the switch to the switching-on state according to a switch-on control signal from the communication module or according to restarting of an operation mode of the electric load device.

The call signal may be a signal from an external server communicating with the communication module, or an operating-on signal of an external remote controller.

The signal from the external server or the operating-on signal of the external remote controller may be a signal that changes the standby mode or a power-off state of the electric load device to an operation mode.

The external server may be a home network server communicating with the communication module.

The power metering module may store power consumption environment patterns of the electric load device, which are classified into at least an operation mode and the standby mode, measure power consumption of the electric load device, transmit the measured power consumption value to the communication module when the measured result value corresponds to the operation mode, and switch off the switch when the measured result value corresponds to the standby mode and the standby mode is held for more than the preset time.

The power metering module may store power consumption environment patterns of the electric load device which are classified into at least an operation mode, the standby mode, and a power-off, measures power consumption of the electric load device, transmit the measured power consumption value to the communication module when the measured result value corresponds to the operation mode, and switch off the switch when the measured result value corresponds to the standby mode and the standby mode is held for more than the preset time, or when the measured result value corresponds to the power-off.

In accordance with another aspect of the present invention to achieve the object, there is provided a power monitoring apparatus of standby power saving type, which is installed in an electric load device including a charging unit for supplying standby power and measures power consumption of the electric load device, the power monitoring apparatus including: a power metering module configured to operate when supplied with power upon the switching-on of a switch, measure a power consumption situation of the electric load device, transmit a measured result to a communication module, and switch off the switch when a measured external power consumption situation of the electric load device corresponds to a standby mode and the standby mode is held for more than a preset time; and the communication module configured to be supplied with power upon the switching-on of the switch, transmit a power consumption value received from the power metering module to exterior, be supplied with standby power from the charging unit of the electric load device upon the switching-off of the switch to wait for receiving a call signal, and switch on the switch upon reception of the call signal, wherein the power monitoring apparatus is switched on when supplied with some of power being supplied to the electric load device or supplied with power from the electric load device, and supplies the power to the power metering module and the communication module, and the switch is switched off when the external power consumption situation of the electric load device is a power-off state.

The power monitoring apparatus may change from the switching-off state of the switch to the switching-on state according to a switch-on control signal from the communication module or according to restarting of an operation mode of the electric load device.

The call signal may be a signal from an external server communicating with the communication module, or an operating-on signal of an external remote controller.

In accordance with another aspect of the present invention to achieve the object, there is provided an electric load device including a power monitoring apparatus that measures power consumption, wherein the power monitoring apparatus is a power monitoring apparatus of standby power saving type.

The power monitoring apparatus may control a main switch of the electric load device to be off when a standby mode of the electric load device according to a measured result is held for more than the preset time. The power monitoring apparatus may be switched off when the main switch of the electric load device is switched off. The power monitoring apparatus may control the main switch to be switched on, upon reception of the call signal during the standby of the reception.

In accordance with another aspect of the present invention to achieve the object, there is provided a power monitoring method of an electric load device using a power monitoring apparatus, including: measuring a power consumption situation of the electric load device in a power metering module of the power monitoring apparatus, which is supplied with power upon the switching-on of the power monitoring apparatus; transmitting the measured result value to exterior through a communication module of the power monitoring apparatus, which is supplied with power upon the switching-on, for the purpose of power monitoring, when the measured result value in the measuring step corresponds to an operation mode among power consumption environment patterns of the electric load device, which are previously set and stored; switching off a switch of the power monitoring apparatus when the measured result value in the measuring step corresponds to a standby mode among the power consumption environment patterns and the standby mode is held for more than a preset time, or when the measured result value corresponds to a power-off among the power consumption environment patterns of the electric load device; supplying the communication module with standby power charged during the previous switching-on, upon the switching-off of the power monitoring apparatus, and waiting for receiving a call signal; and controlling the switch of the power monitoring apparatus to be switched on, when the communication module receives the call signal in the waiting step.

The power monitoring apparatus may be supplied with some of power being supplied to the electric load device or supplied with power from the electric load device, upon the switching-on of the power monitoring apparatus, supply the power to the power metering module and the communication module, and charge the standby power. The power monitoring apparatus may change from the switching-off state of the switch to the switching-on state according to a switch-on control signal from the communication module or according to restarting of an operation mode of the electric load device.

In the waiting step, the call signal may be a signal from an external server communicating with the communication module, or an operating-on signal of an external remote controller.

### BRIEF DESCRIPTION OF THE DRAWINGS

These and/or other aspects and advantages of the present general inventive concept will become apparent and more readily appreciated from the following description of the embodiments, taken in conjunction with the accompanying drawings of which:

FIG. 1 is a schematic block diagram showing a power monitoring apparatus of standby power saving type in accordance with an embodiment of the present invention;

FIG. 2 is a schematic block diagram showing a power monitoring apparatus of standby power saving type in accordance with another embodiment of the present invention;

FIG. 3 is a schematic block diagram showing a power monitoring apparatus of standby power saving type provided in an electric load device in accordance with another embodiment of the present invention;

FIG. 4 is a schematic flowchart showing a power monitoring method of standby power saving type in accordance with another embodiment of the present invention;

FIG. 5 is a schematic flowchart showing a power monitoring method of standby power saving type in accordance with another embodiment of the present invention; and

FIG. 6 is a schematic block diagram showing a conventional power monitoring apparatus of standby power saving type.

### DETAILED DESCRIPTION OF THE PREFERABLE EMBODIMENTS

Embodiments of the present invention for achieving the above objects will be described with reference to the accompanying drawings. In the specification, like reference numerals denote like elements, and duplicate or redundant descriptions will be omitted for conciseness.

It will be understood that when an element is referred to as being 'connected to' or 'coupled to' another element, it may be directly connected or coupled to the other element or at least one intervening element may be present therebetween. In contrast, when an element is referred to as being 'directly connected to' or 'directly coupled to' another element, there are no intervening element therebetween.

It should be noted that the singular forms 'a' 'an' and 'the' are intended to include the plural forms as well, unless the context clearly indicates otherwise. It should be understood that the terms 'comprise', 'include' and 'have', when used in this specification, specify the presence of stated features or elements, but do not preclude the presence or addition of one or more other features, elements, or combinations thereof.

Hereinafter, a power monitoring apparatus of standby power saving type, an electric load device, and a power monitoring method in accordance with exemplary embodiments of the present invention will be described in detail with reference to the accompanying drawings.

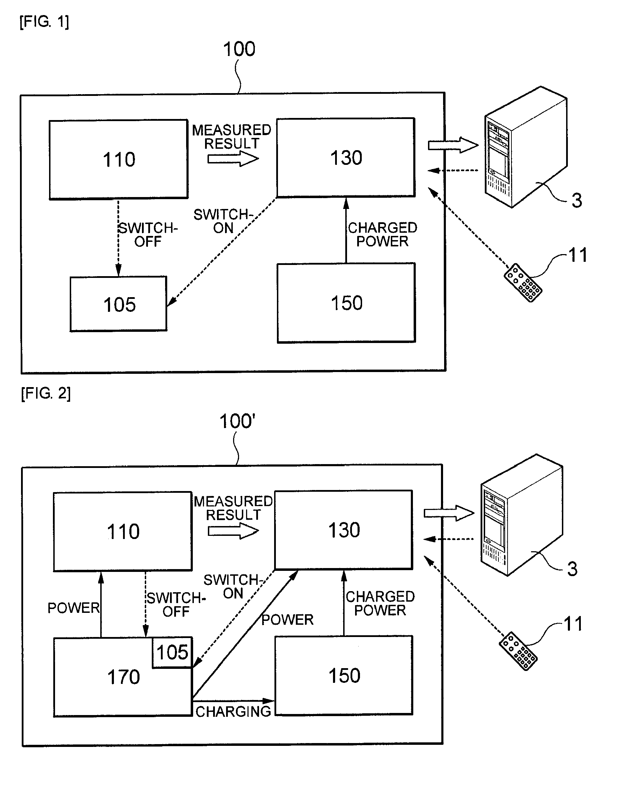

FIG. 1 is a schematic block diagram showing a power monitoring apparatus of standby power saving type in accordance with an embodiment of the present invention, and FIG. 2 is a schematic block diagram showing a power monitoring apparatus of standby power saving type in accordance with another embodiment of the present invention.

A power monitoring apparatus of standby power saving type in accordance with an embodiment of the present invention will be described with reference to FIG. 1 and/or FIG. 2.

Referring to FIG. 1, a power monitoring apparatus 100 of standby power saving type in accordance with an embodiment of the present invention includes a power metering module 110, a communication module 130, and a charging module 150. Referring to FIG. 2, a power monitoring apparatus 100' in accordance with another embodiment of the present invention further includes a power module 170.

Upon the switching-on, the power metering module 110 is supplied with power to operate. A switch 105 is a power switch for the power monitoring apparatuses 100 and 100'. In accordance with exemplary embodiments, the switch 105 may be provided with a separate switch module, or may be provided with the power module 170 as shown in FIG. 2. The power metering module 110 measures a power consumption situation of an electric load device, and transmits the measured result value to the communication module 130. For example, when the power consumption situation of the electric load device is an operation mode, the power metering module 110 transmits the measured result value to the communication module 130. Even when the power consumption situation of the electric load device is a standby mode, the power metering module 110 may transmit the measured result value to the communication module 130 until before it reaches a preset time. In addition, the power metering module 110 switches off the switch 105 when the standby mode of the electric load device according to the measured result is held for more than a preset time or when the electric load device is powered off.

The power metering module 110 may measure the power consumption situation of the electric load device at set intervals, and transmit the measured result value to the communication module 130. The measurement interval is set and stored on a program executed in the power metering module 110. In this case, the power metering module 110 includes a memory and a processor. The time interval is set and stored in an initial stage, or is defined through a setting modification. In some embodiments, the measurement interval may be different from the interval of transmission to the communication module 130. For example, the interval of transmission to the communication module 130 may be longer than the measurement interval. The time interval setting may be appropriately controlled suitably for the power consumption situation of the electric load device. In this embodiment, the power consumption situation of the electric load device is measured at the set time interval, and the measured result is transmitted. Therefore, power consumption may be reduced, as compared to the conventional real-time measurement.

In the present invention, the operation mode of the electric load device refers to a state in which the electric load device is operating and power is continuously consumed or is continuously consumed at regular intervals, and generally refers to an on operation state of the electric load device. Also, the operation mode refers to an on operation state of the electric load device, including a maximum power usage mode and a power saving mode. The standby mode refers to an off operation state of the electric load device, or a state in which the electric load device consumes minimum standby power, or a state in which the electric load device waits for a restart command signal, and generally refers to a minimum power standby mode. In addition, the power-off of the electric load state refers to a state in which the power consumption of the electric load device is zero. In this specification, the power-off of the electric load device refers to a state in which no external power is supplied to the electric load device and thus external power consumption is zero. The standby mode of the electric load device generally refers to a state in which the electric load device waits for changing to the operation mode or the on operation state, while consuming minimum external power. The electric load device may not change to the operation mode for a predetermined time during the standby mode, but change to the power-off state, depending on the electric load device.

In an embodiment of the present invention, in a case where the power monitoring apparatuses 100 and 100' are dependent on the power switch (not shown) of the electric load device and are not supplied with power due to the power-off of the electric load device, the power metering module 110 need not separately switch off the switch. For example, if the switch 105 is a FET switch, the switch 105 is immediately switched off. In a case where the power metering module 110 switches off the switch 105 when the electric load device is powered off, the power monitoring apparatuses 100 and 100' of the present invention are suitable for embodiments in which they are connected not to be dependent on the power switch of the electric load device.

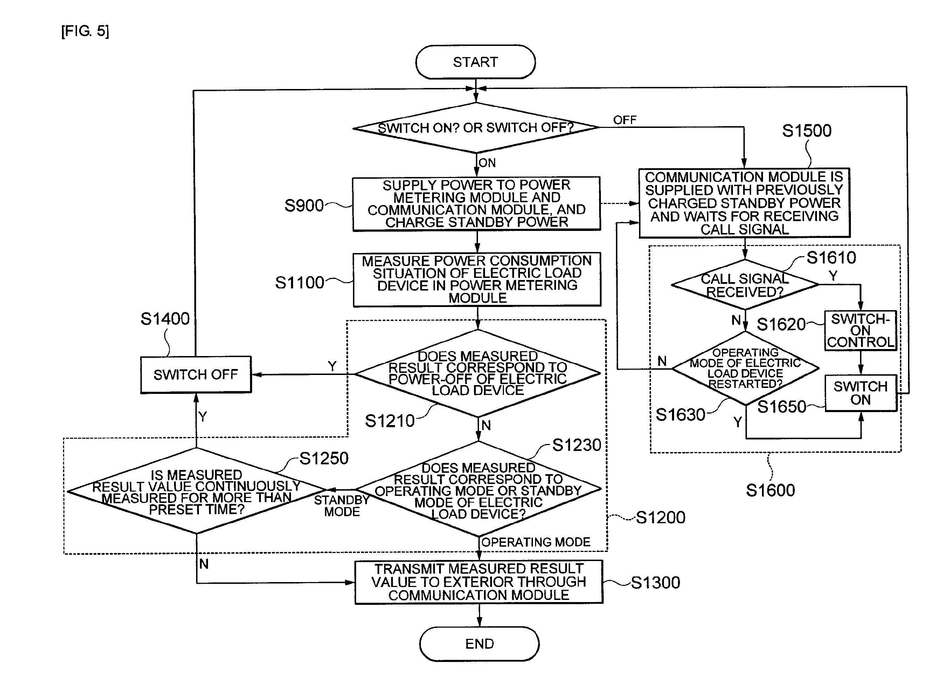

In accordance with another embodiment of the present invention, the power metering module 110 stores power consumption environment patterns of the electric load device, which are classified into at least an operation mode and the standby mode. The power metering module 110 measures power consumption of the electric load device, and transmits the measured power consumption value to the communication module 130 when the measured result value corresponds to the operation mode. The power metering module 110 may measure the power consumption of the electric load device at set intervals, and transmit the measured result value to the communication module 130. Referring to reference numeral S1250 of FIG. 5, even when the measured result value corresponds to the standby mode and thus the electric load device consumes general minimum standby power, the power metering module 110 transmits the measured result value to the communication module 130 until before a preset time.

In this embodiment, when the measured result value corresponds to the standby mode of the electric load device and the standby mode is held for more than the preset time, or when the measured result value corresponds to the power-off of the electric load device, the power metering module 110 switches off the switch 105.

Moreover, in accordance with another embodiment, the power metering module 110 stores power consumption environment patterns of the electric load device, which are classified into at least an operation mode, a standby mode, and a power-off. The power metering module 110 measures power consumption of the electric load device, and transmits the measured power consumption value to the communication module 130 when the measured result value corresponds to the operation mode. Even when the measured result value corresponds to the standby mode, the power metering module 110 may transmit the measured result value to the communication module 130 until before a preset time. The power metering module 110 may measure the power consumption of the electric load device at set intervals, and transmit the measured result value to the communication module 130. The power metering module 110 switches off the switch 105, when the measured result value corresponds to the standby mode of the electric load device and the standby mode is held for more than the preset time, or when the measured result value corresponds to the power-off of the electric load device.

The communication module 130 will be described with reference to FIG. 1 and/or FIG. 2. The communication module 130 is supplied with power upon the switching-on, and transmits the power consumption value received from the power metering module 110 to the exterior. The interval at which the communication module 130 receives the power consumption value from the power metering module 110 may be set to be equal to or different from the interval at which the communication module 130 transmits the power consumption value to the exterior. In some cases, the interval at which the communication module 130 transmits the power consumption value to the exterior may be set to be longer than the interval at which the communication module 130 receives the power consumption value from the power metering module 110. At this time, the time interval setting may be appropriately controlled suitably for the power consumption situation of the electric load device. Upon switch-off, the communication module 130 enters a save mode of a communication protocol (a mode of waiting for receiving an external call signal) to thereby minimize power consumption, and the communication module 130 is supplied with charged power to thereby reduce a total external power consumption.

In addition, upon the switching-off of the switch 105, the communication module 130 is supplied with standby power and waits for receiving a call signal. Upon the reception of the call signal, the communication module 130 switches on the switch 105. In this case, the standby power is supplied through the charging module 150.

Another embodiment of the present invention will be described with reference to FIG. 1 and/or FIG. 2. A call signal is a signal from the external server 3 communicating with the communication module 130, or an operating-on signal of an external remote controller 11. The signal from the external server 3 may be a measured result submission request signal or a measurement restart request signal from, for example, a home network server, or may be a signal for changing the standby mode or the power-off state of the electric load device to the operation mode through a remote control. The operating-on signal of the external remote controller 11 may be a signal for changing the standby mode or the power-off state of the electric load device to the operation mode through a remote control.

In accordance with another embodiment, the signal from the external server 3 or the operating-on signal of the external remote controller 11 is a signal for changing the standby mode or the power-off state of the electric load device to the operation mode.

In addition, in an embodiment, the external server 3 is a home network server communicating with the communication module 130.

Next, the charging module 150 will be described with reference to FIG. 1 and/or FIG. 2. The charging module 150 starts charging upon the switching-on, and supplies standby power to the communication module 130 upon switch-off of the switch 105. In a case where the charging module completes the charging in the switch-on state, the supply of power for charging is stopped.

Another embodiment of the present invention will be described below with reference to FIG. 2.

The power monitoring apparatus 100' of the standby power saving type in accordance with the embodiment of the present invention further includes the power module 170. The power module 170 is supplied with some of power that is supplied to the electric load device or is supplied with power from the electric load device upon the switching-on, and supplies the power to the power metering module 110, the communication module 130, and the charging module 150. In this case, as shown in FIG. 2, the switch 105 may be a part of the power module 170, or may be a separate switch module. The power module 170 may be supplied with external power in such a way that the power module 170 is supplied with some of power being supplied to the electric load device, or is supplied with power from the electric load device. In the case where the power module 170 is supplied with some of power being supplied to the electric load device, the power monitoring apparatus 100' may be installed before a main power switch (not shown) of the electric load device. At this time, even when the electric load device is in a power-off state, the switch 105 may be continuously in the on state and thus power may be consumed. Therefore, when the electric load device is in the power-off state, the switch 105 of the power monitoring apparatus 100' is also switched off. In the case where the power module 170 is supplied with power from the electric load device, the power monitoring apparatus 100' is dependent on the power switch (not shown) of the electric load device and thus the power monitoring apparatus 100' may be also powered off when the electric load device is powered off. Also, although the power monitoring apparatus 100' is dependent on the power switch of the electric load device, the power monitoring apparatus 100' may be continuously supplied with standby power even when the electric load device is in an off state. For example, in the case where although the power monitoring apparatus 100' is dependent on the power switch (not shown) of the electric load device, the power monitoring apparatus 100' is continuously supplied with the standby power even when the electric load device is in the off state, the power monitoring apparatus 100' may be switched off when the electric load device is switched off, so as to reduce power consumption.

Another embodiment of the present invention will be described with reference to reference numeral S1600 of FIG. 5. When the power module 170 changes from the switching-off state of the switch to the switching-on state according to a switch-on control signal from the communication module 130 or according to restarting of an operation mode of the electric load device. The switch-on control signal from the communication module 130 is a control signal for switching on the switch 105 according to the reception of a call signal. In this case, the call signal is a signal from the external server 3 communicating with the communication module 130 or an operating-on signal of the external remote controller 11. For example, the call signal may be a signal for changing the standby mode or the power-off state of the electric load device to the operation mode through a remote control in the external server 3 or the external remote controller 11.

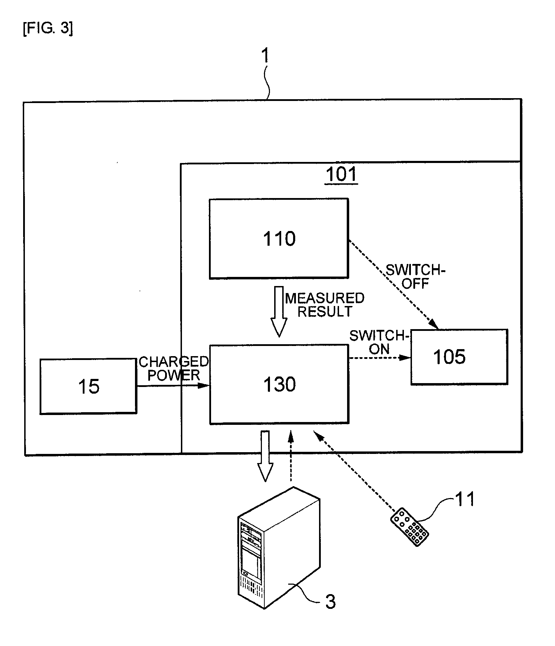

FIG. 3 is a schematic block diagram showing a power monitoring apparatus of standby power saving type, which is provided in an electric load device, in accordance with another embodiment of the present invention. In FIG. 3, an electric load device 1 includes a power monitoring apparatus 101 of standby power saving type in accordance with an embodiment of the present invention.

Referring to FIG. 3, in accordance with an embodiment of the present invention, the power monitoring apparatus 101 is installed in the electric load device 1 including a charging unit 15 for supplying standby power, and measures power consumption of the electric load device 1. The power monitoring apparatus 101 in accordance with the embodiment of the present invention includes a power metering module 110 and a communication module 130.

In this embodiment, the power monitoring apparatus 101 is switched on when supplied with some of power being supplied to the electric load device 1 or is supplied power from the electric load device 1. When switched on, the power monitoring apparatus 101 supplies the power to the power metering module 110 and the communication module 130. In addition, in a case where an external power consumption situation of the electric load device 1 is a power-off state, the switch 105 is switched off. The power monitoring apparatus 101 may be switched on when supplied with power from the electric load device 1. In this case, the power monitoring apparatus 101 may be dependent on a power switch (not shown) of the electric load device 1 and be switched off when the electric load device 1 is powered off.

In this embodiment, the power metering module 110 operates when supplied from power upon the switching-on, measures a power consumption situation of the electric load device 1, and transmits the measured result to the communication module 130. The power metering module 110 switches off the switch 105 when the external power consumption situation of the electric load device 1 according to the measured result is a standby mode and holds the standby mode for more than the preset time. The power metering module 110 measures the power consumption situation of the electric load device 1 at set intervals, and transmits the measured result value to the communication module 130.

Next, the communication module 130 is supplied with power upon the switching-on, and transmits the power consumption value received from the power metering module 110 to the exterior, for example, the external server 3. When the switch 105 is switched off, the power metering module 110 is supplied with standby power from the charging unit 15 of the electric load device 1, and waits for receiving the call signal. When the power metering module 110 receives the call signal, the power metering module 110 switches on the switch 105.

The descriptions about the embodiments of FIG. 1 and/or FIG. 2 are equally referred to in the embodiments of FIG. 3, unless otherwise defined or limited.

Another embodiment of the present invention will be described below with reference to FIG. 3. The power monitoring apparatus 101 changes from the switching-off state of the switch to the switching-on state according to a switch-on control signal from the communication module 130 or according to restarting of an operation mode of the electric load device 1. The switch-on control signal from the communication module 130 is a control signal for switching on the switch 105 according to the reception of the control signal.

In accordance with another embodiment of the present invention, the call signal is a signal from the external server 3 communicating with the communication module 130 or an operating-on signal of the external remote controller 11. The signal from the external server 3 or the operating-on signal of the external remote controller 11 may be a signal for changing the standby mode or the power-off state of the electric load device 1 to the operation mode.

As another invention for solving the technical problems, embodiments of the electric load device including the power monitoring apparatus will be described below. In the following description of the embodiments, the descriptions about the embodiments of the power monitoring apparatuses 100, 100' and 101 of the standby power saving type shown in FIG. 1, FIG. 2 and/or FIG. 3 are equally referred to in the present embodiments, unless otherwise defined or limited.

In according to an embodiment of the present invention, in the electric load device including the respective power monitoring apparatus 100, 100' or 101 measuring power consumption, the power monitoring apparatuses 100 and 100' may be the power monitoring apparatuses 100 and 100' of the standby power saving type, which includes the power metering module 110, the communication module 130, and the charging module 150, as shown in FIG. 1 and/or FIG. 2, may be the power monitoring apparatus 100' of the standby power saving type, which further includes the power module 170, as shown in FIG. 2, or may be the power monitoring apparatus 101 of the standby power saving type, which includes the power metering module 110 and the communication module 130, as shown in FIG. 3, and is supplied with standby power from the charging unit 15 of the electric load device 1 and waits for receiving the call signal.

Moreover, in accordance with another embodiment of the electric load device, the power monitoring apparatuses 100, 100' and 101 provided in the electric load device controls the main switch of the electric load device (for example, the power switch) (not shown) to be switched off when the standby mode of the electric load device according to the measured result is held for more than the preset time. Accordingly, standby power consumption may be prevented in the electric load devices as well as the power monitoring apparatuses 100, 100' and 101. In addition, the power monitoring apparatuses 100, 100' and 101 are switched off when the main switch (not shown) of the electric load device is switched off. When receiving the call signal during the call signal reception waiting state, the power monitoring apparatuses 100, 100' and 101 control the main switch (not shown) of the electric load device to be switched on.

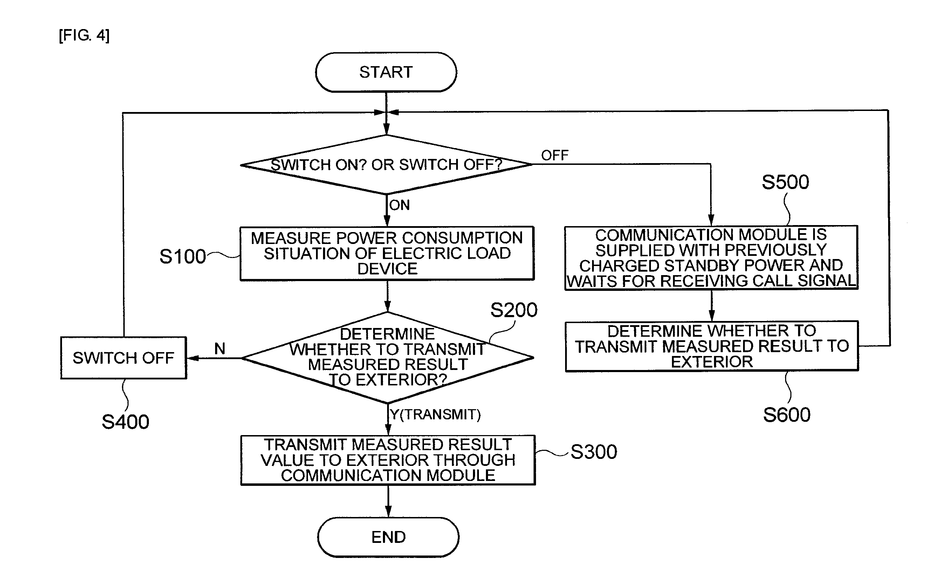

As another aspect of the present invention, a power monitoring method of standby power saving type will be described below with reference to the drawings. The following descriptions will be given focusing on FIG. 4 and/or FIG. 5, and the descriptions about the components of the power monitoring apparatuses of FIG. 1, 2 and/or 3 will be referred to herein.

FIG. 4 is a schematic flowchart showing a power monitoring method of standby power saving type in accordance with another embodiment of the present invention, and FIG. 5 is a schematic flowchart showing a power monitoring method of standby power saving type in accordance with another embodiment of the present invention.

Power monitoring methods of an electric load device using a power monitoring apparatus will be described below with reference to FIG. 4 and/or FIG. 5. Power monitoring methods of standby power saving type in accordance with embodiments of the present invention include measuring steps S100 and S1100, power consumption transmitting steps S300 and S1300, standby power saving steps S400 and S1400, waiting steps S500 and S1500, and operation restarting steps S600 and S1600, respectively. It should be noted that reference numerals of FIG. 4 and/or FIG. 5 do not represent a temporal order, but distinguish the respective steps. That is, although the power consumption transmitting steps S300 and S1300 and the standby power saving steps S400 and S1400 are performed after the measuring steps S100 and S1100, a temporal order relationship is not established between the power consumption transmitting steps S300 and S1300 and the standby power saving steps S400 and S1400. In addition, the measuring steps S100 and S1100 and the waiting steps S500 and S1500 are determined according to the on or off operation of the switch 105, and a strict temporal order does not exist therebetween.

First, the measuring steps S100 and S1100 will be described below. When the power monitoring apparatuses 100, 100' and 101 are switched on, the power metering module 110 of the respective power monitoring apparatuses 100, 100' and 101 supplied with power measures a power consumption situation of the electric load device. The power metering module 110 may measure the power consumption situation of the electric load device at set intervals. The interval may be initially set and stored, or may be set through a setting modification.

When the power consumption of the electric load device is measured in the measuring steps S100 and S1100, it is determined whether to transmit the measured result to the exterior in steps S200, S1200. As shown in FIG. 5, the determination may include step S1210 of measuring whether the measured result corresponds to a power-off state of the electric load device, step S1230 of determining whether the measured result value corresponds to a standby mode or a power-off state of the electric load device, and step S1250 of determining whether the measured result value corresponding to the standby mode is continuously measured for more than the preset time. In this case, the operation mode, standby mode and power-off patterns of the electric load device are previously classified and stored.

Thereafter, in the power consumption transmitting steps S300 and S1300, when the measured result value in the above-described measuring steps S100 and S1100 corresponds to the operation mode among the previously stored power consumption environment patterns of the electric load device, the measured result value is transmitted to the exterior through the communication module 130 of the respective power monitoring apparatuses 100, 100' and 101 supplied with power upon the switching-on, for the purpose of power monitoring. Referring to FIG. 5, even when the power consumption environment of the electric load device is the standby mode, the measured result value may be transmitted to the communication module 130 until before a preset time.

For example, the power consumption environment patterns of the electric load device classified into at least the operation mode and the standby mode, or classified into at least the operation mode, the standby mode, and the power-off state are previously stored.

Thereafter, in the standby power saving steps S400 and S1400, the switch 105 of the respective power monitoring apparatuses 100, 100' and 101 is switched off when the measured result value in the above-described measuring steps S100 and S1100 corresponds to the standby mode among the power consumption environment patterns of the electric load device and is held for more than the preset time, or when the measured result value corresponds to the power-off state among the power consumption environment patterns of the electric load device.

In the waiting steps S500 and S1500, when the power monitoring apparatuses 100, 100' and 101 are switched off, the communication module 130 is supplied with standby power charged upon the switching-on and waits for receiving the call signal.

Another embodiment of the present invention will be described below with reference to FIG. 5. Referring to reference numeral S900 of FIG. 5, the power module 170 is supplied with some of power being supplied to the electric load device upon the switching-on of the power monitoring apparatuses 100 and 100', or is supplied with power from the electric load device. Then, the power module 170 supplies the power to the power metering module 110 and the communication module 130, and is charged with the standby power. At this time, the charged standby power is supplied to the communication module 130 of the waiting steps S500 and S1500.

As another embodiment, referring to FIG. 3, the standby power is supplied from the charging unit 15 of the electric load device 1.

Moreover, in accordance with another embodiment of the present invention, the call signal in the above-described waiting steps S500 and S1500 is a signal from the external server 3 communicating with the communication module 130 or an operating-on signal of the external remote controller 11. The standby mode or the power-off state of the electric load device may be changed to the operation mode through a remote control signal from the external server 3 or the external remote controller 11.

In an embodiment, the signal from the external server 3 or the operating-on signal of the external remote controller 11 is a signal for changing the standby mode or the power-off state of the electric load device to the operation mode. In addition, the external server 3 is a home network server communicating with the communication module 130.

In the operation restarting steps S600 and S1600, when the communication module 130 receives the call signal in the above-described waiting steps S500 and S1500 (S1610), the communication module 130 controls the switch 105 of the respective power monitoring apparatuses 100, 100' and 101 to be switched on.

Another embodiment of the present invention will be described below with reference to FIG. 5. Referring to reference numeral S1600 of FIG. 5, the power monitoring apparatuses 100, 100' and 101 change from the switch-off state to the switch-on state (S1650) according to the switch-on control signal from the communication module 130 (S1620) or the operation mode restart of the electric load device (S1630). The switch-on control signal from the communication module 130 is a control signal for switching on the switch 105 (S1620) upon the reception of the call signal (S1610).

In accordance with an aspect of the present invention, the power monitoring apparatus of the standby power saving type, the electric load device including the same, and the power monitoring method of the standby power saving type may be implemented to shut down or save the standby power that is separately consumed in the power monitoring apparatus in the standby power mode of the electric load device.

In accordance with an embodiment of the present invention, the standby power separately consumed in the power monitoring apparatus may be shut down or saved. In addition, the standby power consumed in the electric load device including the power monitoring apparatus may also be saved.

It is apparent that various effects not directly described above may be derived from various elements in accordance with the embodiments of the present invention by those skilled in the art.

As described above, although the preferable embodiments of the present invention have been shown and described, it will be appreciated by those skilled in the art that substitutions, modifications and variations may be made in these embodiments without departing from the principles and spirit of the general inventive concept, the scope of which is defined in the appended claims and their equivalents.

## Claims

1. A power monitoring apparatus of standby power saving type, comprising:
a power metering module configured to operate when supplied with power upon the switching-on of a switch, measure a power consumption situation of an electric load device, transmit a measured result to a communication module, and switch off the switch when a standby mode of the electric load device according to the measured result is held for more than a preset time or when the electric load device is powered off;
the communication module configured to be supplied with power upon the switching-on of the switch, transmit a power consumption value received from the power metering module to exterior, be supplied with standby power upon the switching-off of the switch to wait for receiving a call signal, and switch on the switch upon reception of the call signal; and
a charging module configured to start charging upon the switching-on of the switch, and supply standby power to the communication module upon the switching-off.

2. The power monitoring apparatus according to claim 1, further comprising:
a power module configured to be supplied with some of power being supplied to the electric load device or be supplied with power from the electric load device upon the switching-on, and supply the power to the power metering module, the communication module, and the charging module.

3. The power monitoring apparatus according to claim 2, wherein the power module changes from the switching-off state of the switch to the switching-on state according to a switch-on control signal from the communication module or according to restarting of an operation mode of the electric load device.

4. The power monitoring apparatus according to claim 1, wherein the call signal is a signal from an external server communicating with the communication module, or an operating-on signal of an external remote controller.

5. The power monitoring apparatus according to claim 4, wherein the signal from the external server or the operating-on signal of the external remote controller is a signal that changes the standby mode or a power-off state of the electric load device to an operation mode.

6. The power monitoring apparatus according to claim 5, wherein the external server is a home network server communicating with the communication module.

7. The power monitoring apparatus according to claim 1, wherein the power metering module stores power consumption environment patterns of the electric load device, which are classified into at least an operation mode and the standby mode, measures power consumption of the electric load device, transmits the measured power consumption value to the communication module when the measured result value corresponds to the operation mode, and switches off the switch when the measured result value corresponds to the standby mode and the standby mode is held for more than the preset time.

8. The power monitoring apparatus according to claim 1, wherein the power metering module stores power consumption environment patterns of the electric load device, which are classified into at least an operation mode, the standby mode, and a power-off, measures power consumption of the electric load device, transmits the measured power consumption value to the communication module when the measured result value corresponds to the operation mode, and switches off the switch when the measured result value corresponds to the standby mode and the standby mode is held for more than the preset time, or when the measured result value corresponds to the power-off.

9. A power monitoring apparatus of standby power saving type, which is installed in an electric load device including a charging unit for supplying standby power and measures power consumption of the electric load device, the power monitoring apparatus comprising:
a power metering module configured to operate when supplied with power upon the switching-on of a switch, measure a power consumption situation of the electric load device, transmit a measured result to a communication module, and switch off the switch when a measured external power consumption situation of the electric load device corresponds to a standby mode and the standby mode is held for more than a preset time; and
the communication module configured to be supplied with power upon the switching-on of the switch, transmit a power consumption value received from the power metering module to exterior, be supplied with standby power from the charging unit of the electric load device upon the switching-off of the switch to wait for receiving a call signal, and switch on the switch upon reception of the call signal,
wherein the power monitoring apparatus is switched on when supplied with some of power being supplied to the electric load device or supplied with power from the electric load device, and supplies the power to the power metering module and the communication module, and the switch is switched off when the external power consumption situation of the electric load device is a power-off state.

10. The power monitoring apparatus according to claim 9, wherein the power monitoring apparatus changes from the switching-off state of the switch to the switching-on state according to a switch-on control signal from the communication module or according to restarting of an operation mode of the electric load device.

11. The power monitoring apparatus according to claim 9, wherein the call signal is a signal from an external server communicating with the communication module, or an operating-on signal of an external remote controller.

12. An electric load device comprising a power monitoring apparatus that measures power consumption, wherein the power monitoring apparatus is a power monitoring apparatus of standby power saving type according to claim 1.

13. The electric load device according to claim 12, wherein:
the power monitoring apparatus controls a main switch of the electric load device to be off when the standby mode of the electric load device according to the measured result is held for more than the preset time;
the power monitoring apparatus is switched off when the main switch of the electric load device is switched off; and
the power monitoring apparatus controls the main switch to be switched on, upon reception of the call signal during the standby of the reception.

14. An electric load device comprising a power monitoring apparatus that measures power consumption, wherein the power monitoring apparatus is a power monitoring apparatus of standby power saving type according to claim 9.

15. The electric load device according to claim 14, wherein:
the power monitoring apparatus controls a main switch of the electric load device to be off when the standby mode of the electric load device according to the measured result is held for more than the preset time;
the power monitoring apparatus is switched off when the main switch of the electric load device is switched off; and
the power monitoring apparatus controls the main switch to be switched on, upon reception of the call signal during the standby of the reception.

16. A power monitoring method of an electric load device using a power monitoring apparatus, comprising:
measuring a power consumption situation of the electric load device in a power metering module of the power monitoring apparatus, which is supplied with power upon the switching-on of the power monitoring apparatus;
transmitting the measured result value to exterior through a communication module of the power monitoring apparatus, which is supplied with power upon the switching-on, for the purpose of power monitoring, when the measured result value in the measuring step corresponds to an operation mode among power consumption environment patterns of the electric load device, which are previously set and stored;
switching off a switch of the power monitoring apparatus when the measured result value in the measuring step corresponds to a standby mode among the power consumption environment patterns and the standby mode is held for more than a preset time, or when the measured result value corresponds to a power-off among the power consumption environment patterns of the electric load device;
supplying the communication module with standby power charged during the previous switching-on, upon the switching-off of the power monitoring apparatus, and waiting for receiving a call signal; and
controlling the switch of the power monitoring apparatus to be switched on, when the communication module receives the call signal in the waiting step.

17. The power monitoring method according to claim 16, wherein:
the power monitoring apparatus is supplied with some of power being supplied to the electric load device or supplied with power from the electric load device, upon the switching-on of the power monitoring apparatus, supplies the power to the power metering module and the communication module, and charges the standby power; and
the power monitoring apparatus changes from the switching-off state of the switch to the switching-on state according to a switch-on control signal from the communication module or according to restarting of an operation mode of the electric load device.

18. The power monitoring method according to claim 16, wherein, in the waiting step, the call signal is a signal from an external server communicating with the communication module, or an operating-on signal of an external remote controller.
